# EUROPEAN PATENT SPECIFICATION

(11) **EP 3 406 752 B1**
(45) Date of publication and mention of the grant of the patent: **08.11.2023**
(21) Application number: 17172252.3
(22) Date of filing: 22.05.2017
(51) Int. Cl.: C23C 14/12, C23C 14/24, H10K 71/16, H10K 71/00, C08G 77/04, C07F 7/21, C08G 77/24

(54) **METHOD FOR PREPARING AN ELECTRONIC DEVICE**
VERFAHREN ZUM ERSTELLEN EINER ELEKTRONISCHEN VORRICHTUNG
PROCÉDÉ DE PRÉPARATION D'UN DISPOSITIF ÉLECTRONIQUE

(43) Date of publication of application: 28.11.2018
(73) Proprietor: Novaled GmbH, 01099 Dresden (DE)
(72) Inventor: Scholz, Johannes, 01307 Dresden (DE); Senkovskyy, Volodymyr, 01307 Dresden (DE)
(74) Representative: Bittner, Thomas L.

(56) References cited:
- US-A1- 2010 304 106
- US-A1- 2013 102 793
- US-A1- 2013 319 522
- US-B1- 6 472 076
- US-B1- 6 517 958
- ELLEN L. HEELEY ET AL: "Linear Long Alkyl Chain Substituted POSS Cages: The Effect of Alkyl Chain Length on the Self-Assembled Packing Morphology", MACROMOLECULES, vol. 46, no. 12, 25 June 2013 (2013-06-25) , pages 4944-4954, XP055417560, US ISSN: 0024-9297, DOI: 10.1021/ma400635e
- MATEUSZ JANETA ET AL: "High-Yield Synthesis of Amido-Functionalized Polyoctahedral Oligomeric Silsesquioxanes by Using Acyl Chlorides", CHEMISTRY - A EUROPEAN JOURNAL, vol. 20, no. 48, 24 November 2014 (2014-11-24), pages 15966-15974, XP055443789, DE ISSN: 0947-6539, DOI: 10.1002/chem.201404153

## Description

The present invention relates to a method for preparing an electronic device.

### Description of related Art

The application of low refractive index materials in OLED may improve the performance. Commonly used materials either possess a very high (LiF) or a very low (alkane, perfluorinated alkanes) evaporation temperature which renders them difficult to be processed together with other organic materials using vacuum thermal evaporation VTE for OLED manufacturing. Process issues arise if the evaporation temperatures of materials are not matched resulting in instable deposition process and inhomogeneous layer composition. This is particularly relevant in mass production of OLED.

A further problem with commercially available low refractive index materials is their bad purity level prior to the processing. This may cause process instabilities and uncontrolled side reactions during the VTE deposition process. This may result in inhomogeneous and impure layers which lead in turn to bad OLED device performance, reliability and long term stability. The deposition of layers in done in sequenced evaporation cycles which is time consuming and costly. Materials with relatively low evaporation temperatures (rate onset ~150°C) show also instability of evaporation temperature in the sequenced evaporation cycles, which make them less suitable for VTE processing in mass production.

US 6 472 076 B1 discloses an array of alkyl substituted silsesquioxane thin film precursors having a structure wherein alkyl groups are bonded to the silicon atoms of a silsesquioxane cage. The alkyl groups may be the same as, or different than the other alkyl groups. In a first aspect, the present invention provides a composition comprising a vaporized material having the formula [R-SiO1.5]x[H-SiO1.5]y, wherein x+y=n, n is an integer between 2 and 30, x is an integer between 1 and n and y is a whole number between o and n. R is a C1 to C100 alkyl group. Also provided are films made from these precursors and objects comprising these films.

US 2010/304106 A1 discloses a gas barrier laminate film including an organic compound layer and an oxide inorganic compound layer and having both excellent gas barrier properties and durability. The gas barrier laminate film comprises an organic compound layer, a silicon atom-containing compound layer on the organic compound layer, and an inorganic compound oxide layer on the silicon atom-containing compound layer.

ELLEN L. HEELEY ET AL: "Linear Long Alkyl Chain Substituted POSS Cages: The Effect of Alkyl Chain Length on the Self-Assembled Packing Morphology", MACROMOLECULES, vol. 46, no. 12, 25 June 2013 (2013-06-25), pages 4944-4954.

MATEUSZ JANETA ET AL: "High-Yield Synthesis of Amido-Functionalized Polyoctahedral Oligomeric Silsesquioxanes by Using Acyl Chlorides", CHEMISTRY - A EUROPEAN JOURNAL, vol. 20, no. 48, 24 November 2014 (2014-11-24), pages 15966-15974.

US 2013/319522 A1 discloses fine-structure layered product, and a preparation method of a fine-structure layered product using the fine-structure layered product for enabling a fine concavo-convex structure excellent in environmental resistance, weather resistance and long-term stability to be formed with a large area and high productivity, and provide a manufacturing method of a fine-structure product for enabling a large area to be made with high productivity, a fine-structure layered product of the invention is provided with a substrate, a resin layer that is formed on one main surface of the substrate and that has a fine concavo-convex structure on its surface, and an inorganic layer that is provided on the fine concavo-convex structure of the resin layer and that contains a sol-gel material having a fine concavo-convex structure in a shape associated with the fine concavo-convex structure of the resin layer, where a fluorine element concentration (Es) in a region on the inorganic layer side of the resin layer is higher than an average fluorine concentration (Eb) in the resin layer.

US 2013/102793 A1 discloses a new functionalized polyhedral octavinylsilsesquioxanes having the general formula 1, in which R1 denotes: (1) any aryl group other than a non-substituted phenyl or a phenyl substituted in position four with a halogen or the groups-trimethylsilylethynyl, 4,4,5,5-tetramethyl-1,3-dioxaborolane-2-yl, 3 ,4-dimethoxyphenyl, 3', 5'-bis(methoxycarbonyl)phenyl or benzo[d][1,3]-dioxol-5-yl; (2) any heteroaryl group; or (3) groups including coupled aromatic rings. Additionally, a method to obtain new and known functionalized polyhedral octavinylsilsesquioxanes having the general formula 1, by the silylating coupling of octavinylsilsesquioxane with olefins in the presence of a ruthenium complex catalyst.

### Summary

It is, therefore, the object of the present invention to provide a novel method for preparing an electronic device overcoming drawbacks of the prior art, in particular a method allowing easy processing of a low refractive index material for incorporating the same into an electronic device, such as an OLED, in a homogenous layer substantially free of unwanted components like impurities and thereby increasing the device performance, the reliability thereof and long term stability.

This object is achieved in accordance with the subject matter of the independent claim.

Further embodiments result from the subclaims.

This object is achieved by a method for preparing an electronic device according to claim 1.

In one embodiment the silsesquioxane compound is substantially free of homologous silsesquioxanes with x < 6.

In a further embodiment the silsesquioxane compound is substantially free of homologous silsesquioxanes with x > 16.

In another embodiment the method comprises a further step prior to step a) of reacting a compound represented by the general formula SiₓHₓO_{1.5x} with an unsaturated hydrocarbon compound comprising R to obtain the silsesquioxane compound (SiₓRₓO_{1.5x}).

In one embodiment the unsaturated hydrocarbon compound comprising R is an olefin compound.

Unsaturated hydrocarbon compounds in the sense of this invention are hydrocarbons that have double or triple covalent bonds between adjacent carbon atoms. Those with at least one carbon-to-carbon double bond are called alkenes and those with at least one carbon-to-carbon triple bond are called alkynes. Unsaturated hydrocarbons, except for aromatic compounds, are highly reactive and undergo addition reactions to their multiple bonds.

In a preferred embodiment the unsaturated hydrocarbon compounds comprise at least one carbon-carbon double bond and/or at least one carbon-carbon triple bond. Typical reagents added are hydrogen halides, water, sulfuric acid, elemental halogens and alcohols.

In an embodiment the unsaturated hydrocarbon compound comprises at least one vinyl group.

In another embodiment the unsaturated hydrocarbon compound is 1,2,3,4,5-pentafluoro-6-vinylbenzene.

In a further embodiment the method comprises a further step prior to step a) of treating the silsesquioxane compound with an acid.

In another embodiment the acid is a inorganic acid.

An increased level of purity of the silsesquioxane compound may be achieved by treatment of the silsesquioxane compound or a solution thereof with acid.

In an embodiment the acid is an inorganic acid, preferably a mineralic acid which may be selected from the group of hydrochloric acid HCl, nitric acid HNO₃, phosphoric acid H₃PO₄, sulfuric acid H₂SO₄, boric acid H₃BO₃, hydrofluoric acid HF, hydrobromic acid HBr, perchloric acid HClO₄, hydroiodic acid HI.

In another embodiment the acid is an organic acid which may be selected from the group of carboxylic acids, substituted carboxylic acids, aromatic carboxylic acids, sulphonic acids, aryl sulphonic acids or phosphonic acids.

In an embodiment the acid is a mixture of different inorganic acids.

In another embodiment the acid is a mixture of different organic acids.

In a further embodiment the acid is a mixture of inorganic and organic acids.

The concentration of the acid or the acid mixture may be larger than about 0.01 mol / liter and smaller than about 12 mol / liter, preferably larger than about 0.1 mol / liter and smaller than about 5 mol / liter, more preferred larger than about 1 mol / liter and smaller than about 3 mol / liter.

In one embodiment the method comprises a further step prior to step a) of treating the silsesquioxane compound with thermal energy.

An increased level of purity of the silsesquioxane compound may be achieved by treatment of the silsesquioxane compound or a solution thereof with thermal energy.

In an embodiment the treatment of the silsesquioxane compound or a solution thereof with thermal energy uses temperatures between about 200°C and about 400°C, preferably between about 230 °C and about 350 °C, more preferred between about 250 °C and about 300 °C.

Further described herein is a compound represented by the general formula SiₓRₓO_{1.5x}, wherein R is a hydrocarbyl group which may comprise at least one heteroatom selected from the group consisting of B, Si, N, P, O and S, the hydrocarbyl group comprising at least one aromatic or heteroaromatic moiety which is partially or fully substituted with at least one substitutent, wherein the at least one substituent is selected from the group consisting of halogen and CN; x is selected from 6, 8, 10, 12, 14 and 16; and the silsesquioxane compound is substantially free of partially condensed silsesquioxanes structures, wherein compounds with x being 8, 10 or 12 and R being -C₃H₆C₆F₅; and x being 8 and R being -C₆F₅ are excluded.

In one embodiment the compound is represented by the general formula (I) 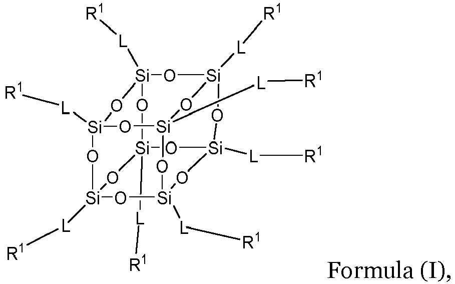 wherein R¹ is a group having 2 to 20 carbon atoms and comprising at least one fluorinated or perfluorinated carbocycle or heterocarbocycle, wherein the fluorinated carbocycle or heterocarbocycle may be unsubstituted or substituted with at least one substituent, selected from the group consisting of alkyl, fluorinated alkyl and perfluorinated alkyl; wherein the group R¹ may further comprise at least one heteroatom selected from the group, consisting of B, Si, N, P, O and S; and L is independently selected from (CH₂)ₙ and/or (CF₂)ₘ and /or (C_{z}HₓF_{y}) wherein n and m are integer values ≥ 0, x = 2z-y and x is an integer ≥ 1, y = 2z-x and y is an integer ≥ 1 and z is an integer value ≥ 1.

In a further embodiment the group R¹ comprises at least one fluorinated or perfluorinated carbocycle or perfluorinated carbocycle or herterocarbocycle is fluorinated or perfluorinated C₆-C₂₀-aryl, fluorinated or perfluorinated C₇-C₂₀ arylalkyl, fluorinated or perfluorinated C₂-C₂₀ heteroaryl or fluorinated or perfluorinated C₃-C₂₀ heteroarylalkyl, provided that at least one fluorine atom is located at a carbocycle or heterocarbocycle part of the group R¹.

The number of carbon atoms (n in Cₙ) in R, respectively R¹, encompasses all carbon atoms in R (R¹) including the carbon atoms of the substituents.

In a preferred embodiment the groups R and R¹ may be fluorinated or perfluorinated C₆-C₂₀-aryl or fluorinated of perfluorinated C₇-C₂₀ arylalkyl.

In another preferred embodiment the groups R and R¹ may be perfluorinated C₆-C₂₀-aryl or perfluorinated C₇-C₂₀ arylalkyl.

In another embodiment the compound has the formula

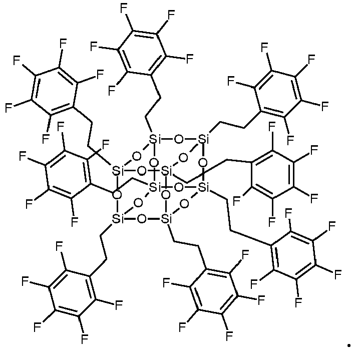

Further described herein is an electronic device comprising at least one inventive compound.

In a further embodiment the electronic device is an organic light emitting diode.

In another embodiment the compound of formula (I) is used in a layer together with an electron transport matrix and an n-type dopant.

In the following, the invention shall be described in greater detail by referring to different embodiments thereof. The different embodiments refer to may both separately and in combination of two or more of these embodiment be a possible realization of the invention.

### Electronic device

The silsesquioxane compound prepared by the method according to the invention is comprised in an electroluminescent device. The electroluminescent device may be a light emitting diode (LED). The electroluminescent device maybe an organic light emitting diode (OLED). The electroluminescent device may be a light emitting transistor. The electroluminescent device may be an organic light emitting transistor (OLET).

Another aspect is directed to an electronic device comprising at least one organic light-emitting diode (OLED). A device comprising organic light-emitting diodes (OLED) is for example a display or a lighting panel.

Another aspect is directed to an electronic device comprising at least one organic light-emitting transistor (OLET). A device comprising organic light-emitting transistors (OLET) is for example a display or a lighting panel.

The electroluminescent device may be constituted of a sequence of layers which are adjoined to each other. The sequence of layers may be arranged between the anode electrode and the cathode electrode of an organic light emitting diode. In another embodiment the sequence of layers may be arranged between the source electrode and/or the drain electrode and/or the gate electrode of an organic light emitting transistor.

The silsesquioxane compound may be comprised in one layer of the sequence of layers. The silsesquioxane compound may be comprised in more than one layer of the sequence of layers. The silsesquioxane compound may be comprised in the electron transport region of the electroluminescent device. In this case it may be preferable that the layer comprising the silsesquioxane compound also comprises an n-type dopant and an electron transport matrix compound.

The silsesquioxane compound may be comprised in the hole transport region of the electroluminescent device. In this case it may be preferable that the layer comprising the silsesquioxane compound also comprises a p-type dopant and a hole transport matrix compound.

The silsesquioxane compound may be comprised in an emission layer.

At least one layer in the sequence of layers may consist of the silsesquioxane compound.

Additional aspects and/or advantages of the invention will be set forth in part of the present description which follows and, in part, will be obvious from the description, or may be learned by practice of the invention.

Described herein is an electronic device comprising at least one electroluminescent device according to any embodiment described throughout this application, preferably, the electronic device comprises the organic light emitting diode in one of embodiments described throughout this application. More preferably, the electronic device is a display device. "Substantially free" in the sense of this invention is to be understood as "not measurable by 1H-NMR". If a signal is not visible above the noise level of the 1H-NMR spectrum it is assumed to be within the measurement uncertainty of the 1H-NMR method and not measurable as an individual signal.

In this regard the term "substantially free" corresponds to a residual concentration of partially condensed silsesquioxanes in the silsesquioxane compound of < 5 molar percent, preferably <2 molar percent, more preferred <1 molar percent, even more preferred < 0.5 molar percent.

### p-Type Dopant

p-type dopants used as guest compounds in mixtures with host compounds commonly increase the conductivity of this compound in comparison to the neat compound. This is provided as a result of electron transfer from HOMO of the host (hole transporting material) to the LUMO of the dopant. A suitable p-dopant, also named redox p-type dopant, is generally a molecule or radical with a LUMO level equal to HOMO of the host or below it. In some cases, the p-type dopant having LUMO level slightly above the HOMO level of the host are also applicable, but the difference of frontier orbital energies in these cases should not be higher than 0.5 eV, preferably not higher than 0.3 eV. The p-type dopant may be neutral or electrically charged.

The p-type dopant may be selected from the group comprising:
- hexaazatriphenylene;
- cyanobenzoquinone-dimethanes and/or cyanobenzoquinone-diimines;
- radialene compounds, preferably [3]-radialene compounds;
- tris(1-(pyridin-2-yl)-1H-pyrazol)cobalt(III) tris(hexafluorophosphate);
- Molybdenum tris-[1,2-bis(trifluoromethyl)ethane-1,2-dithiolene];
- C₆₀F_{48;}
- charge neutral metal amide compounds;
- metal organic complex, preferably a group Vb/VIb/VIIb metal organic complex, wherein at least one ligand is substituted with at least four electron withdrawing groups selected from the group comprising fluorine, chlorine, bromine and/or nitrile.

According to another embodiment the p-type dopant may be preferably selected from the group comprising hexaazatriphenylene.

According to another embodiment the p-type dopant may be preferably selected from the group comprising cyanobenzoquinone-dimethanes and/or cyanobenzoquinone-diimines.

According to another embodiment the p-type dopant may be preferably selected from the group comprising radialene compounds, preferably [3]-radialene compounds.

According to another embodiment the p-type dopant may be selected from the group comprising tris(1-(pyridin-2-yl)-1H-pyrazol)cobalt(III) tris(hexafluorophosphate).

According to another embodiment the p-type dopant may be Molybdenum tris-[1,2-bis(trifluoromethyl)ethane-1,2-dithiolene].

According to another embodiment the p-type dopant may be a fluorinated fullerene, preferably C₆₀F₄₈.

According to another embodiment the p-type dopant may be preferably selected from the group comprising charge neutral metal amide compounds.

According to another embodiment the p-type dopant may be preferably selected from the group comprising a metal organic complex, preferably a group Vb/VIb/VIIb metal organic complex.

According to another embodiment the p-type dopant may be selected from the group of p-type dopants having the following chemical formula (PD-1) to (PD-11): 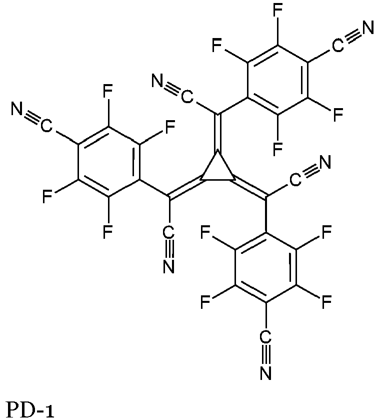 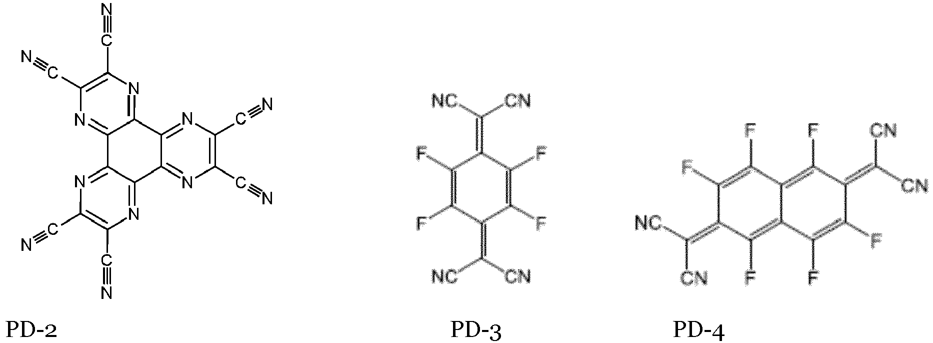 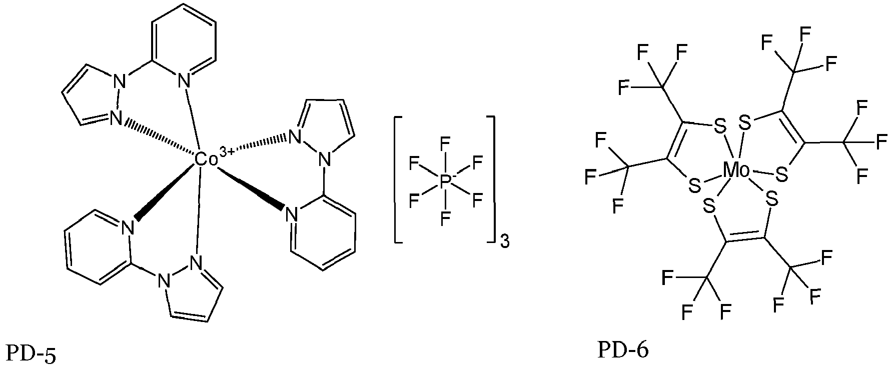 C₆₀F₄₈ (PD-7), 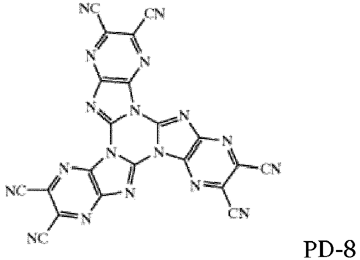 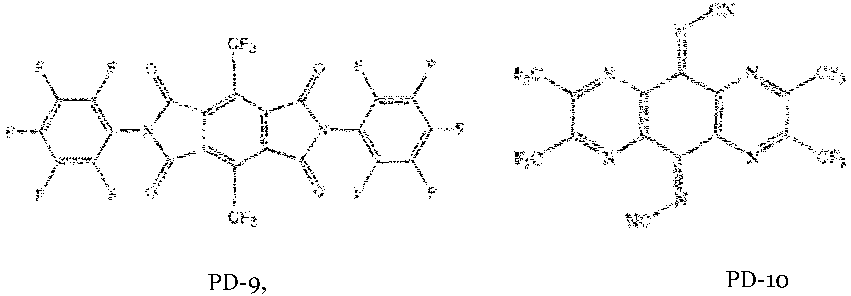 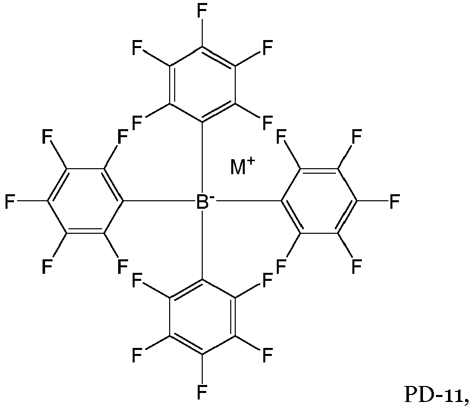 wherein M⁺ is a monovalent cation, preferably an alkali cation.

### Hole Transport Matrix Compound

The hole transport layers may comprise hole transport materials. Compounds that may be suitable are disclosed for example in Yasuhiko Shirota and Hiroshi Kageyama, Chem. Rev. 2007, 107, 953-1010, and incorporated by reference.

### n-Type Dopant

Under n-type dopant, it is understood a compound which, if embedded into an electron transport or electron injection layer, increases the concentration of free electrons in comparison with the neat matrix under the same physical conditions in a way that the conductivity of a layer comprising the n-type dopant is higher than the conductivity of the neat matrix layer.

The n-type dopant does not emit light under the operation condition of an electroluminescent device, for example an OLED. In one embodiment, the n-type dopant is selected from an electrically neutral metal complex and/or an electrically neutral organic radical.

The most practical benchmark for the strength of an n-type dopant is the value of its redox potential. There is no particular limitation in terms how negative the value of the redox potential can be.

As redox potentials of usual electron transport matrices used in organic light emitting diodes are, if measured by cyclic voltammetry against ferrocene/ferrocenium reference redox couple, roughly in the range from about - 1.8 V to about - 3.1V; the practically applicable range of redox potentials for n-type dopants which can effectively n-dope such matrices is in a slightly broader range, from about - 1.7 V to about - 3.3 V.

The measurement of redox potentials is practically performed for a corresponding redox couple consisting of the reduced and of the oxidized form of the same compound.

In case that the n-type dopant is an electrically neutral metal complex and/or an electrically neutral organic radical, the measurement of its redox potential is actually performed for the redox couple formed by
(i) the electrically neutral metal complex and its cation radical formed by an abstraction of one electron from the electrically neutral metal complex, or
(ii) the electrically neutral organic radical and its cation formed by an abstraction of one electron from the electrically neutral organic radical.

Preferably, the redox potential of the electrically neutral metal complex and/or of the electrically neutral organic radical may have a value which is more negative than - 1.7 V, preferably more negative than - 1.9 V, more preferably more negative than - 2.1 V, even more preferably more negative than - 2.3 V, most preferably more negative than - 2.5 V, if measured by cyclic voltammetry against ferrocene/ferrocenium reference redox couple for a corresponding redox couple consisting of
(i) the electrically neutral metal complex and its cation radical formed by an abstraction of one electron from the electrically neutral metal complex, or
(ii) the electrically neutral organic radical and its cation formed by an abstraction of one electron from the electrically neutral organic radical.

In a preferred embodiment, the redox potential of the n-type dopant is between the value which is about 0.5 V more positive and the value which is about 0.5 V more negative than the value of the reduction potential of the chosen electron transport matrix.

Electrically neutral metal complexes suitable as n-type dopants may be e.g. strongly reductive complexes of some transition metals in low oxidation state. In an embodiment the n-type dopant may be selected from Cr(II), Mo(II) and/or W(II) guanidinate complexes such as W₂(hpp)₄, as described in more detail in WO2005/086251.

Electrically neutral organic radicals suitable as n-type dopants may be e.g. organic radicals created by supply of additional energy from their stable dimers, oligomers or polymers, as described in more detail in EP 1 837 926 B1, WO2007/107306, or WO2007/107356. Specific examples of such suitable radicals may be diazolyl radicals, oxazolyl radicals and/or thiazolyl radicals.

Elemental metal are suitable as n-type dopants. Under an elemental metal it is understood a metal in a state of a neat metal, of a metal alloy, or in a state of free atoms or metal clusters. It is understood that metals deposited by vacuum thermal evaporation from a metallic phase, e.g. from a neat bulk metal, vaporize in their elemental form. It is further understood that if the vaporized elemental metal is deposited together with a covalent matrix, the metal atoms and/or clusters are embedded in the covalent matrix. In other words, it is understood that any metal doped covalent material prepared by vacuum thermal evaporation contains the metal at least partially in its elemental form.

For the use in consumer electronics, only metals containing stable nuclides or nuclides having very long halftime of radioactive decay might be applicable. As an acceptable level of nuclear stability, the nuclear stability of natural potassium can be taken.

In one embodiment, the n-type dopant is selected from electropositive metals selected from alkali metals, alkaline earth metals, rare earth metals and metals of the first transition period Ti, V, Cr and Mn. Preferably, the n-type dopant is selected from Li, Na, K, Rb, Cs, Mg, Ca, Sr, Ba, Sm, Eu, Tm, Yb; more preferably from Li, Na, K, Rb, Cs, Mg, Ca and Yb, even more preferably from Li, Mg, Ca and Yb.

In another embodiment the n-type dopant is Yb (ND-1).

In an embodiment the concentration of the electropositive metal in the electron transport matrix compound is in the range from about 0.5 weight % up to about 25 weight %, preferably in the range from about 1 to about 20 weight %, more preferably in the range from about 2 to about 15 weight %, most preferably in the range from about 3 to about 10 weight %.

In a further embodiment the n-type dopant may be selected from complexes of transition metals in low oxidation state such as Cr(II), Mo(II) and/or W(II) guanidinate complexes.

In another embodiment the n-type dopant is selected from or is a compound represented by one of the following formulae 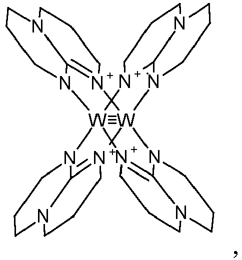 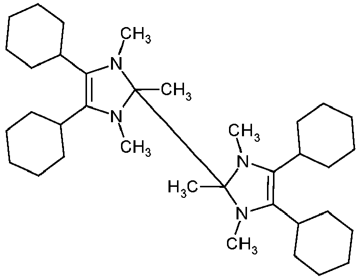 or mixtures thereof.

The n-type dopant may be essentially non-emissive.

### Electron Transport Matrix Compound

Various embodiments of the electron transport region in the device according to invention, e.g. devices comprising hole blocking layers, electron injection layers, may comprise an electron transport matrix compound.

The electron transport matrix is not particularly limited. Similarly as other materials which are in the inventive device comprised outside the emitting layer, the electron transport matrix may not emit light.

According to one embodiment, the electron transport matrix can be an organic compound, an organometallic compound, or a metal complex.

According to one embodiment, the electron transport matrix may be a covalent compound comprising a conjugated system of at least 6 delocalized electrons. Under a covalent material in a broadest possible sense, it might be understood a material, wherein at least 50 % of all chemical bonds are covalent bonds, wherein coordination bonds are also considered as covalent bonds. In the present application, the term encompasses in the broadest sense all usual electron transport matrices which are predominantly selected from organic compounds but also e.g. from compounds comprising structural moieties which do not comprise carbon, for example substituted 2,4,6-tribora-1,3,5 triazines, or from metal complexes, for example aluminium tris(8-hydroxyquinolinolate).

The molecular covalent materials can comprise low molecular weight compounds which may be, preferably, stable enough to be processable by vacuum thermal evaporation (VTE). Alternatively, covalent materials can comprise polymeric covalent compounds, preferably, compounds soluble in a solvent and thus processable in form of a solution. It is to be understood that a polymeric substantially covalent material may be crosslinked to form an infinite irregular network, however, it is supposed that such crosslinked polymeric substantially covalent matrix compound still comprises both skeletal as well as peripheral atoms. Skeletal atoms of the covalent compound are covalently bound to at least two neighbour atoms. Other atoms of the covalent compound are peripheral atoms which are covalently bound with a single neighbour atom. Inorganic infinite crystals or fully crosslinked networks having partly covalent bonding but substantially lacking peripheral atoms, like silicon, germanium, gallium arsenide, indium phosphide, zinc sulfide, silicate glass etc. are not considered as covalent matrices in the sense of present application, because such fully crosslinked covalent materials comprise peripheral atoms only on the surface of the phase formed by such material. A compound comprising cations and anions is still considered as covalent, if at least the cation or at least the anion comprises at least ten covalently bound atoms.

Preferred examples of covalent electron transport matrix compounds are organic compounds, consisting predominantly from covalently bound C, H, O, N, S, which may optionally comprise also covalently bound B, P, As, Se. In one embodiment, the electron transport matrix compound lacks metal atoms and majority of its skeletal atoms is selected from C, O, S, N.

In another embodiment, the electron transport matrix compound comprises a conjugated system of at least six, more preferably at least ten, even more preferably at least fourteen delocalized electrons.

Examples of conjugated systems of delocalized electrons are systems of alternating pi- and sigma bonds. Optionally, one or more two-atom structural units having the pi-bond between its atoms can be replaced by an atom bearing at least one lone electron pair, typically by a divalent atom selected from O, S, Se, Te or by a trivalent atom selected from N, P, As, Sb, Bi. Preferably, the conjugated system of delocalized electrons comprises at least one aromatic or heteroaromatic ring adhering to the Hückel rule. Also preferably, the electron transport matrix compound may comprise at least two aromatic or heteroaromatic rings which are either linked by a covalent bond or condensed.

In one embodiment the electron transport matrix compound comprises a ring consisting of covalently bound atoms and at least one atom in the ring is phosphorus.

In preferred disclosure, the phosphorus-containing ring consisting of covalently bound atoms is a phosphepine ring.

In another preferred disclosure, the electron transport matrix compound comprises a phosphine oxide group.

In another preferred disclosure the electron transport matrix compound comprises a diazole group.

Also preferably, the substantially covalent matrix compound comprises a heterocyclic ring comprising at least one nitrogen atom. Examples of nitrogen containing heterocyclic compounds which are particularly advantageous as electron transport matrix compound for the inventive device are matrices comprising, alone or in combination, pyridine structural moieties, diazine structural moieties, triazine structural moieties, quinoline structural moieties, benzoquinoline structural moieties, quinazoline structural moieties, acridine structural moieties, benzacridine structural moieties, dibenzacridine structural moieties, diazole structural moieties and benzodiazole structural moieties.

The electron matrix compound may have a molecular weight (Mw) of ≥ 400 to ≤ 850 g / mol, preferably ≥ 450 to ≤ 830 g / mol. If the molecular weight is selected in this range, particularly reproducible evaporation and deposition can be achieved in vacuum at temperatures where good long-term stability is observed.

Preferably, the matrix compound may be essentially non-emissive.

### Emission Layer (EML)

The emission layer (120) may be formed on the first hole transport layer (112) or the second hole transport layer (113) by vacuum deposition, spin coating, slot-die coating, printing, casting, LB, or the like. When the EML is formed using vacuum deposition or spin coating, the conditions for deposition and coating may be similar to those for the formation of the HIL.

However, the conditions for deposition and coating may vary, according to the compound that is used to form the EML.

The emission layer (EML) may be formed of a combination of a host and an emitter dopant. In a preferred embodiment the emission layer consists of a host and an emitter dopant.

Examples of the host are Alq3, 4,4'-N,N'- dicarbazole-biphenyl (CBP), poly(n-vinylcarbazole) (PVK), 9,10-di(naphthalene-2-yl)anthracenee (ADN), 4,4',4"-Tris(carbazol-9-yl)-triphenyl-amine (TCTA), 1,3,5-tris(N-phenylbenzimidazole-2-yl)benzene (TPBI), 3-tert-butyl-9,10-di-2-naphthylanthracenee (TBADN), distyrylarylene (DSA), Bis(2-(2-hydroxyphenyl)benzothiazolate)zinc (Zn(BTZ) 2), E1 to E4 below.

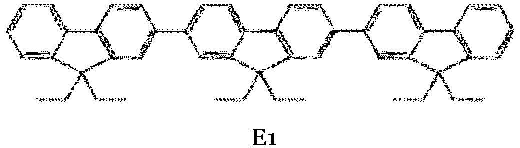

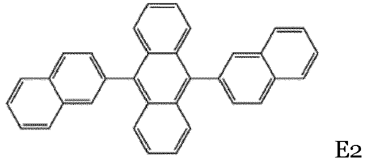

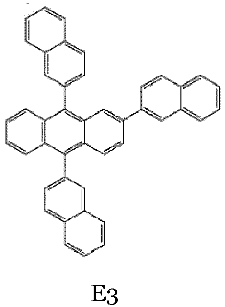

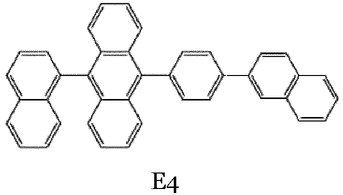

In a preferred embodiment, the emission layer comprises at least one emitter dopant that emits visible light at operation of the OLED.

The emitter dopant may be a phosphorescent or fluorescent emitter. Phosphorescent emitters and emitters which emit light via a thermally activated delayed fluorescence (TADF) mechanism are preferred due to their higher efficiency. The emitter may be a small molecule or a polymer. Examples of a red dopant are PtOEP, Ir(piq)₃, and Btp₂lr(acac), but are not limited thereto. These compounds are phosphorescent emitters, however, fluorescent red dopants could also be used.

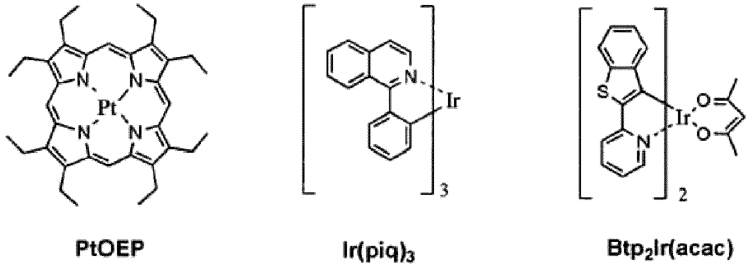

Examples of a phosphorescent green dopant are Ir(ppy)₃ (ppy = phenylpyridine), Ir(ppy)₂(acac), Ir(mpyp)₃ are shown below. Compound E5 is an example of a fluorescent green emitter and the structure is shown below.

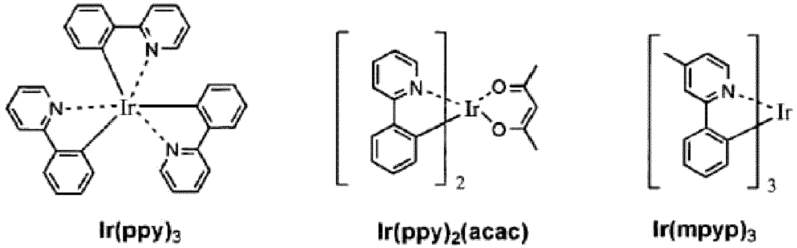

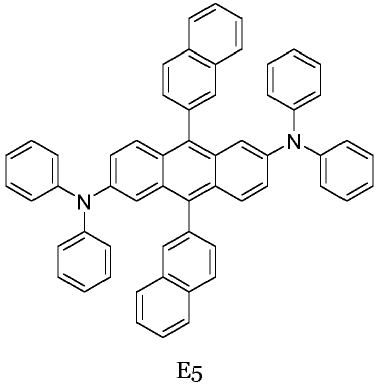

Examples of a phosphorescent blue dopant are F₂Irpic, (F₂ppy)₂Ir(tmd) and Ir(dfppz)₃, ter-fluorene, the structures are shown below. 4.4'-bis(4-diphenyl amiostyryl)biphenyl (DPAVBi), 2,5,8,11-tetra-tert-butyl perylene (TBPe), and Compound E6 below are examples of fluorescent blue dopants.

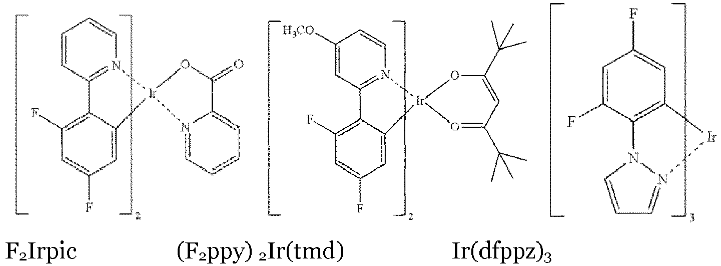

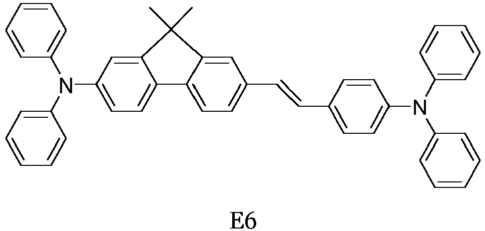

The amount of the dopant may be in the range of about 0.01 to about 50 parts by weight, based on 100 parts by weight of the host.

Alternatively, the emission layer may comprise or consist of a light-emitting polymer. The EML may have a thickness of about 10 nm to about 100 nm, for example, about 20 nm to about 60 nm. When the thickness of the EML is within this range, the EML may have excellent light emission, without a substantial increase in driving voltage.

In a preferred disclosure the emission layer comprising or consisting of the light-emitting polymer is in direct contact with the electron transport region.

In an embodiment the silsesquioxane compound may be comprised in at least one layer arranged on top of that surface of the electroluminescent device through which the light extracts out of the electroluminescent device.

In another embodiment at least one layer which is arranged on top of that surface of the electroluminescent device through which the light extracts out of the electroluminescent device may consist of the silsesquioxane compound.

A layer comprising or consisting of the silsesquioxane compound may be formed by vacuum deposition, spin coating, printing, casting, slot-die coating, Langmuir-Blodgett (LB) deposition, or the like.

When the layer comprising or consisting of the silsesquioxane compound is formed using vacuum deposition, the deposition conditions may vary according to the compound that is used to form the layer comprising the silsesquioxane compound, and the desired structure and thermal properties of the layer. In general, however, conditions for vacuum deposition may include a deposition temperature of 100° C to 500° C, a pressure of 10-8 to 10-3 torr (1 torr equals 133.322 Pa or 1.33322 mbar), and a deposition rate of 0.1 to 10 nm/sec.

When the layer comprising or consisting of the silsesquioxane compound is formed using deposition from solution the coating conditions may include a coating speed of about 2000 rpm to about 5000 rpm, and a thermal treatment temperature of about 80° C to about 200° C. Thermal treatment removes a solvent after the coating.

The electroluminescent device may be arranged on a substrate. The substrate material may be selected from silicon, glass, plastics, metal or paper.

The electroluminescent device comprising the silsesquioxane compound may be a bottom emission OLED. That is when the light extracts out of the OLED through the transparent anode.

The electroluminescent device comprising the silsesquioxane compound may be a top emission OLED. That is when the light extracts out of the OLED through the transparent cathode.

In the following, the invention shall be described in greater detail in an exemplary manner by referring to experiments performed by the inventors using specific compounds and device arrangements which are suitable to exemplify the subject matter of the claims.

### Examples

### Synthesis Example 1 - Preparation of Low-n 1

### 1. Synthesis flow scheme

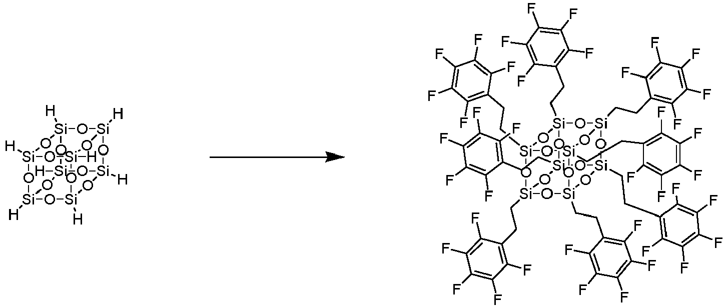

### 2. Synthesis steps

1,3,5,7,9,11,13,15-octakis(2-(perfluorophenyl)ethyl)-2,4,6,8,10,12,14,16,17,18,19,20-dodecaoxa-1,3,5,7,9,11,13,15-octasilapentacyclo[9.5.1.13,9.15,15.17,13]icosane (= Low-n 1)

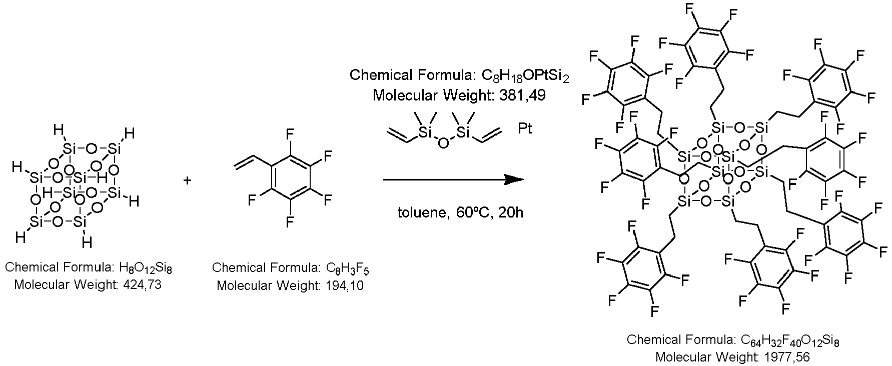

| Starting materials, reagents and solvents involved | Supplier [CAS], purity | used amounts | | | |
|---|---|---|---|---|---|
| | | m [g] | V[mL] | n [mmol] | eq |
| | | | | | |
| 2,4,6,8,10,12,14,16,17,18,19,2 o-dodecaoxa-1,3,5,7,9,11,13,15-octasilapentacyclo[9.5.1.13,9. 15,15.17,13]icosane (POSS-8H) | Synkola, [281-50-5], 100% | 12 | - | 28.25 | 1 |
| 1,2,3,4,5-pentafluoro-6-vinylbenzene | Apollo [653-34-9], 99% | 54.84 | - | 285.53 | 10 |
| Platinum(o)-1,3-divinyl-1,1,3,3-tetramethyldisiloxane complex soulution in xylene | ABCR [68478-92-2] | 0.0138 | - | 0.03 | 0.001 |
| Toluene (extra dry) | Acros [108-88-3], 99.85% | | 60 | | |

Equipment: 250ml, 3-neck round bottom flask, reflux condenser, N₂-inlet, thermometer, septum, magnetic stir-bar

| time | procedure | observation |
|---|---|---|
| 1h | 1,2,3,4,5-pentafluoro-6-vinylbenzene is filtered through short pad (3cm) of Alox (basic) and distilled under reduced pressure and degassed with nitrogen | |
| | Flask is charged with POSS-8H , styrene and toluene, catalyst solution is added by syringe | Exothermic reaction |
| 20h | Stirring at 60°C | Solution (L1) |
| | Filtration of L1 through paperfilter (white ribbon), evaporated to dryness, triturated with methanol (100ml) | White solid (S1) |
| 12h | S1 is dissolved in toluene (20ml), presiptated by methanol (100ml), solid is separated by filtration (sintered glass filter, P4), dried in vacuum at 40°C for 12h | White solid, HPLC=99.78%, |

| Prepared material | Amount (Yield) | HPLC purity | Purity check method |
|---|---|---|---|
| Low-n 1 | 51g (91.28%) | 99.78% | HPLC3_YMC-Triart-C18_isocratic_MeCN_draft composition of the mobile phase kept constant (*"isocratic* elution mode") |

### NMR-Analysis:

1H-NMR (THF-d8, 500MHz) δ = 0.98 - 1.06 (m, 2H), 2.83 - 2.92 (m, 2H) ppm.
13C-NMR (THF-d8, 125 MHz) δ = 12.52 (CH2), 16.4 (CH2) ppm.( Ar-C not observed)
19F-NMR (THF-d8, 470 MHz) δ = -148.25 (2F), -162.07 (1F), -166.36 - -167.11 (m, 1F) ppm.
29Si-NMR (THF-d9, 99 MHz) δ = - 69.81 (CSiO3) ppm.

Note: The 1H-NMR indicates < 1% of elimination to a styrene moiety after the hydrosilylation.

Silsesquioxane compound Low-n 1 above is a preferred example in the sense of this invention. Low-n 1 may be obtained by the specified procedure at very high purity levels. Thus, it may be used in a manufacturing process of electroluminescent devices as synthesized without the need of further purification.

### Synthesis Example 2 - Preparation of Low-n 2

### 1. Low-n 2

1,3,5,7,9,11,13,15,17,19,21,23-dodecakis(3,3,3-trifluoropropyl)-Heptacyclo[11.11.1.13,9.15,21.17,19.111,17.115,23]dodecasiloxane (= Low-n 2)

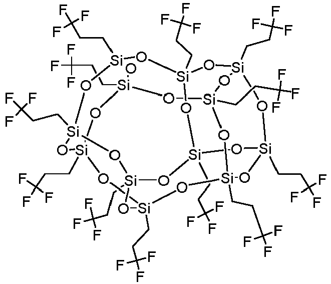

### Crude material was purchased from Hybrid Plastic (USA), product Nr. FL0578 (Trifluoropropyl POSS Cage Mixture)

### 2. Purification

The following procedure has been applied to remove impurities which are presumably only in partially condensed silsesquioxanes, that is, silsesquixanes with silsesquioxane cages which are not fully closed (incomplete ring closure).

| Starting materials, reagents and solvents involved | Supplier, [CAS], purity | used amounts | | | |
|---|---|---|---|---|---|
| | | m [g] | V[mL] | n [mmol] | eq |
| | | | | | |
| 1,3,5,7,9,11,13,15,17,19,21,23-dodecakis(3,3,3-trifluoropropyl)-Heptacyclo[11.11.1.13,9.15,21. 17,19.111,17.115,23]dodecasilo xane (Low-n 2) | Hybrid Plastic (USA), [851814-19-2], >97% according to CoA of supplier | 20 | - | 11.17 | 1 |
| THF | Fisher, [109-99-9], extra pure, stabilized with 0,025% BHT | | 600 | | |
| Hydrochloric acid (32%) | VWR, [7647-01-0] | | | | |
| Water (de-ionized) | central supply | | 60 | | |

### Equipment: 1000mL 1-neck round-bottom flask, magnetic stir-bar, 2M HCl derived by dilution of concentrated HCl

| time | procedure | observation |
|---|---|---|
| 15 min | 20g Low-n 2 (11.17 mmol) is placed in a round bottom flask and dissolved in 600mL THF, slowly 60mL water is added, followed by dropwise addition of 2mL 2M HCl | Clear solution |
| 6h | Stirred at room temperature | |
| 2h | Ca. 500mL of the solvent is distilled of on a rotatory evaporator at 40°C water bath temperature. The obtained suspension is diluted with 200mL methanol and additional stirred for 10min, then filtered off and dried in a vacuum oven at 50°C overnight. | White solid |

The specified procedure provides the silsesquioxane compound Low-n 2 at very high purity levels. It may be used in the manufacturing process of the electroluminescent device as synthesized without the need of further purification.

In the following examples of devices the following low refractive index compounds were used.

| Compound Name | Structure formula |
|---|---|
| Low-n 1 | 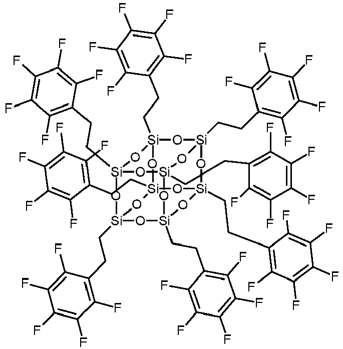 C64H32F40O12Si8 |
| Low-n 2 | 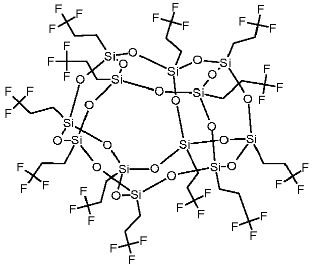 C36H48F36018Si12 |

Furthermore, the following compounds have been used to manufacture the device examples.

| Compound name | Molecular Structure | Reference |
|---|---|---|
| HTM-1 | 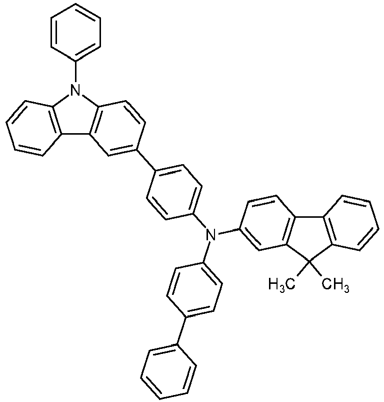 | US2016322581 |
| HTM-2 | 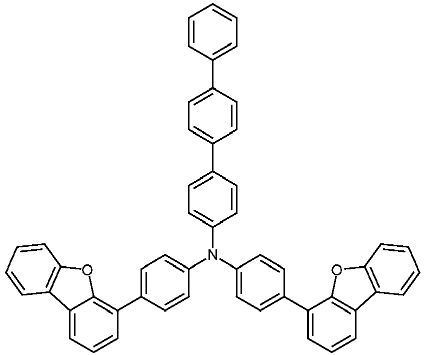 | JP2014096418 A2 |
| PD-1 | 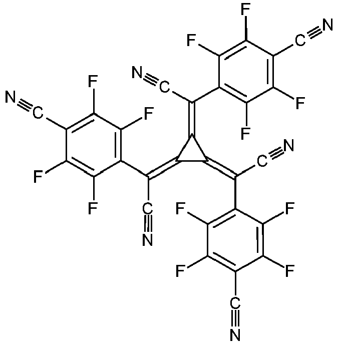 | US2008265216 |
| Host-1 | 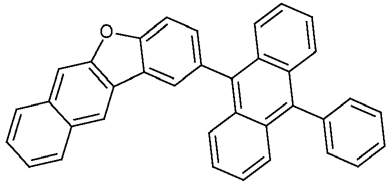 | US2015325800 |
| Emitter-1 BD200 from Sun Fine Chem (SFC), Korea | Not public | |
| ETM-1 | 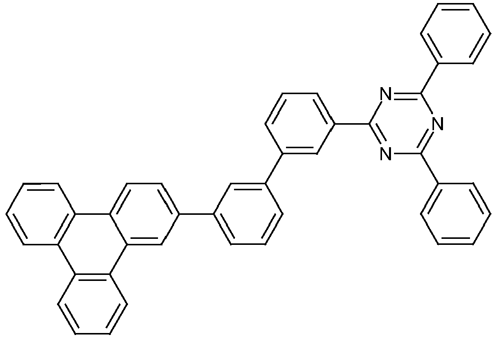 | KR2017011338 |
| ETM-2 | 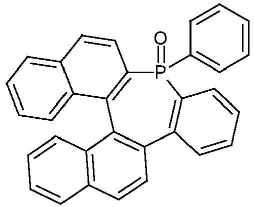 | WO2015097225A1 |
| ND-1 | Ytterbium | WO2015097232A1 |

### Measurement Methods

The NMR spectrometer used was Bruker AV 500 with 5 mm probe head. For the determination of the purity levels of compounds Low-n 1 and Low-n 2 the following method was used: 1H NMR, 500 MHz device, versus internal standard TMS (o ppm)

In the following detailed explanation of the examples, reference will be made to the accompanied drawings.

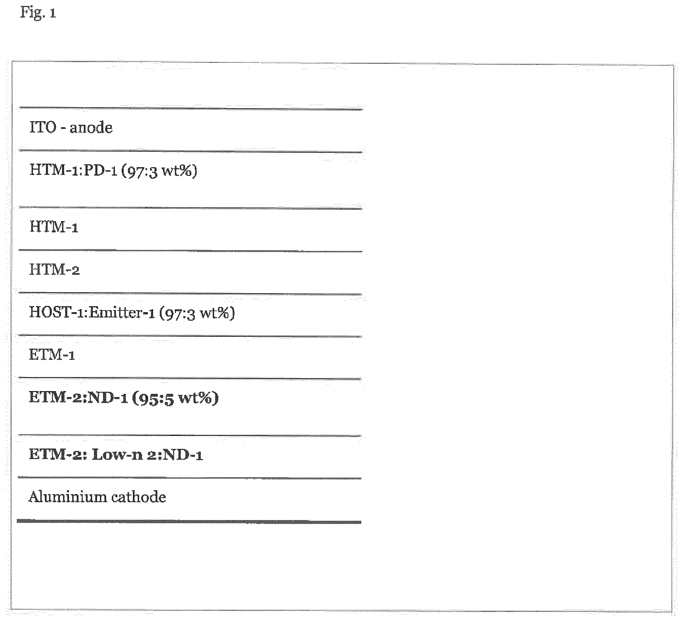

Fig. 1 shows the layer stack used in the OLED device examples, referred to below.

Four different Examples of the inventive OLEDs were prepared using the layer stack shown in Fig. 1. In the inventive layer stacks, different concentrations of electrode transport materials, n-dopants and inventive low refractive silsesquioxanes Low-n 2 were employed. The performance of the respective layer stacks with respect to initial voltage and external quantum efficiency (EQE) where investigated and compared with an OLED using the same electrode transport material and the same dopant but, in contrast to the present invention, no low refractive silsesquioxane. It was surprisingly found by the inventors that by employing the silsesquioxane compounds according to the invention, an improved external quantum efficiency can be achieved.

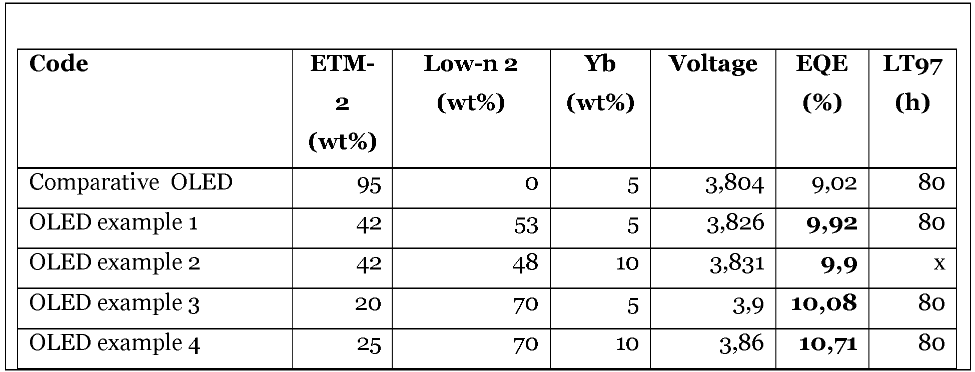

Furthermore, studies as to the purity of the inventive silsesquioxane compounds for use in the inventive electronic device and the inventive method have been performed. The results are summarized below by referring to the accompanying Figures.

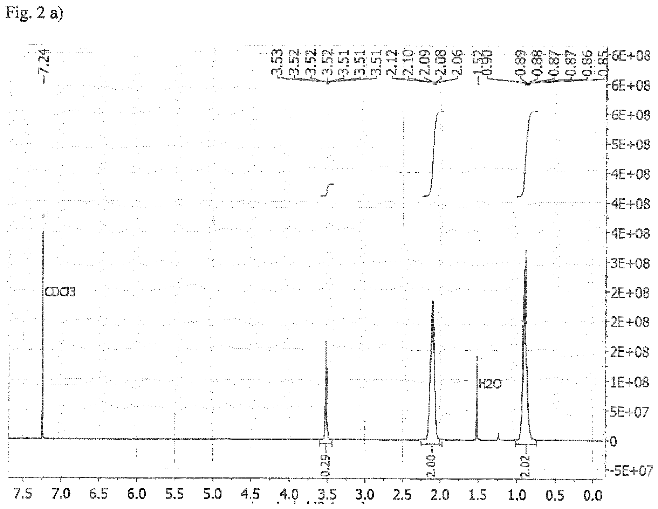

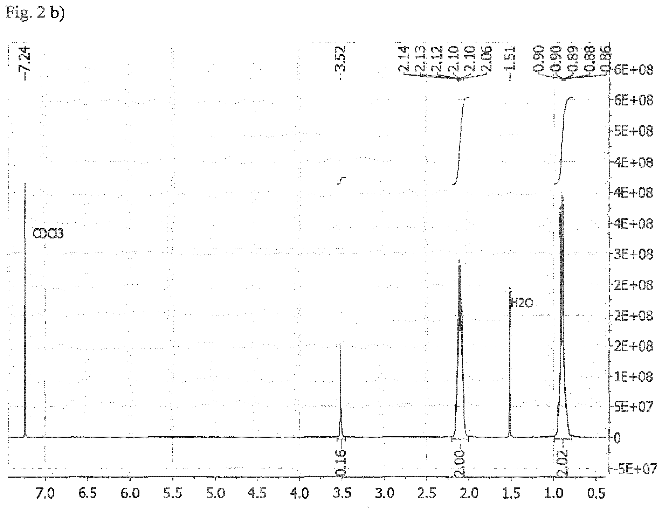

Fig. 2 - 1H-NMR spectrum of material Low-n 2 a) as purchased, unsublimed, 1H-NMR in CDCl₃ solution; b) Low-n 2 after sublimation, 1H-NMR in CDCl₃ solution

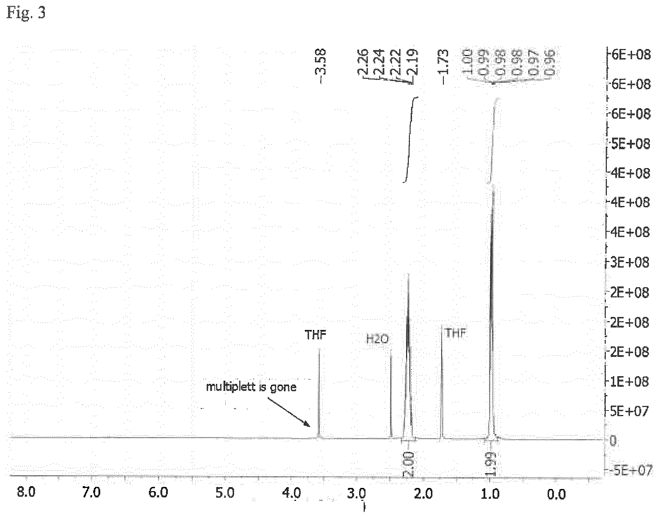

Fig. 3 - 1H-NMR spectrum of Low-n 2 after acid treatment of purchased, unsublimed, material, 1H-NMR in THF-d8 solution

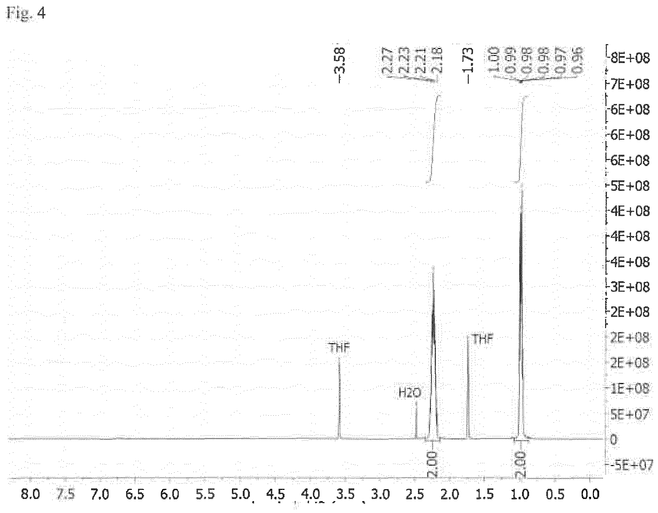

Fig. 4 - 1H-NMR spectrum of Low-n 2 after sublimation of acid-treated material, 1H-NMR in THF-d8 solution

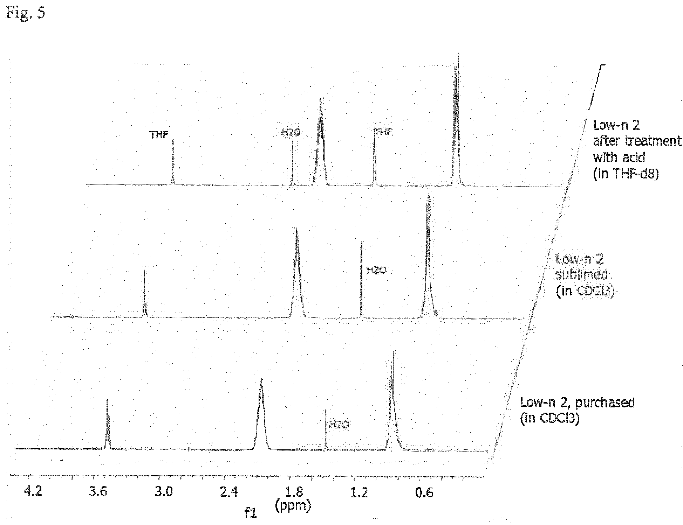

Fig. 5 - Enlarged view of stacked 1H-NMR spectra of Low-n 2, (1) as purchased, (2) after sublimation, (3) after acid treatment. The 1H-NMR signals (multiplett) in the region of 3.5 ppm are attributed to alkyl-groups directly attached to Si-O for example -Si-O-CH₂-. Such groups occur only in partially condensed silsesquioxanes with silsesquioxane cages which are not fully closed (incomplete ring closure). If the 1H-NMR signals in the region of 3.5 ppm are not observed in high-resolution 1H-NMR spectra of a compound it can be concluded that this compound is "substantially free" of partially condensed silsequioxanes. This compound in the main consists of fully condensed silsesquioxanes.

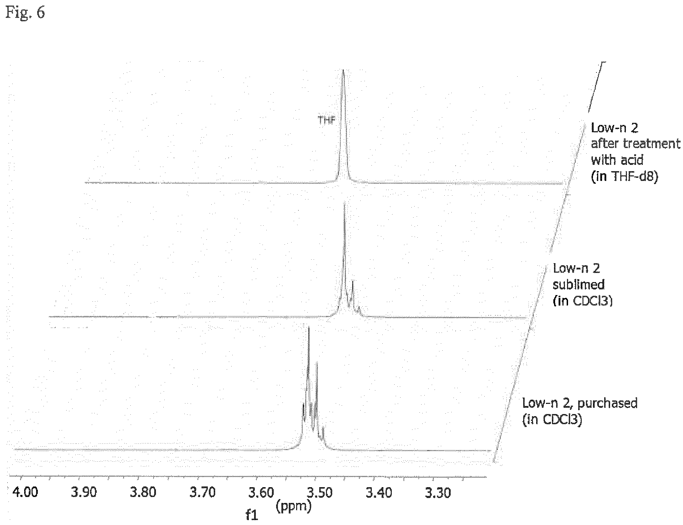

Fig. 6 - Enlarged view of stacked 1H-NMR spectra of Low-n 2 (zoom-in on signal range 3.25 ppm to 4.00 ppm).

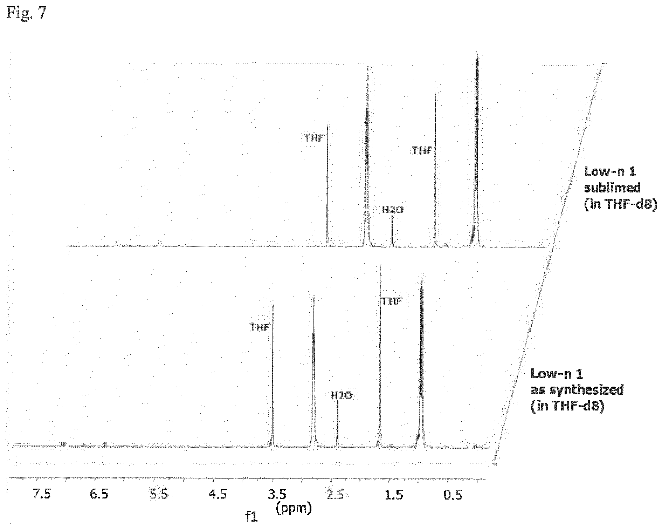

Fig. 7 - Stacked 1H-NMR spectra of Low-n 1, (1) as synthesized, (2) after sublimation, 1H-NMR in THF-d8 solution

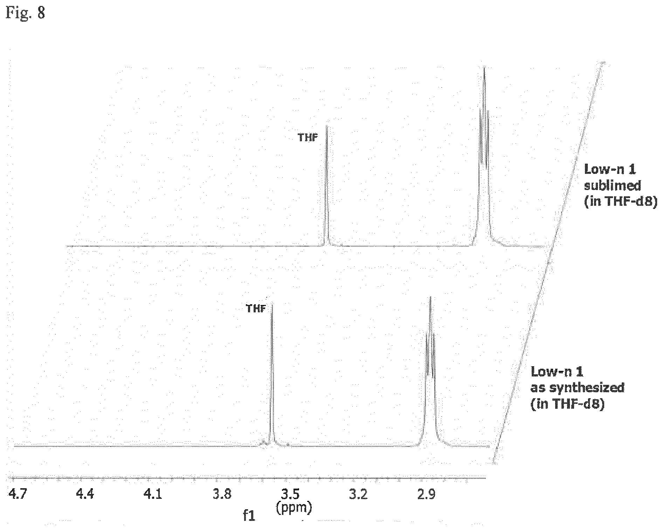

Fig. 8 - Enlarged view of stacked 1H-NMR spectra of Low-n, (1) as synthesized, (2) after sublimation, 1H-NMR in THF-d8 solution. The 1H-NMR signals (multiplett) in the region of 3.5 ppm are not present in the Low-n 1 material after synthesis. It can be concluded that this compound is "substantially free" of partially condensed silsequioxanes after synthesis.

The features disclosed in the foregoing description, in the claims and/or in the accompanying drawings may, both separately and in any combination thereof, be material for realizing the invention in diverse forms thereof.

## Claims

1. Method for preparing an electronic device, the method comprising the steps:
a) providing, in a vaporization source, a silsesquioxane compound represented by the general formula SiₓRₓ0_{1.5x},
wherein
R is a terminal hydrocarbyl group covalently bonded to Si and the terminal hydrocarbyl group, which is substituted with at least one halogen atom and which may in addition comprise at least one heteroatom selected from the group consisting of B, Si, N, P, O and S; and
x is selected from 6, 8, 10, 12, 14 and 16; and
the silsesquioxane compound is substantially free of partially condensed silsesquioxanes meaning that the silsesquioxane compound does not comprise partially condensed silsesquioxanes in amounts measurable by 1H-NMR;
b) vaporizing the silsesquioxane compound by applying thermal energy thereto;
c) depositing the vaporized silsesquioxane compound on a substrate.

2. Method according to claim 1, wherein the silsesquioxane compound is substantially free of homologous silsesquioxanes with x < 6 meaning that the silsesquioxane compound does not comprise homologous silsesquioxanes with x < 6 in amounts measurable by 1 H-NMR.

3. Method according to claim 1 or 2, wherein the silsesquioxane compound is substantially free of homologous silsesquioxanes with x > 16 meaning that the silsesquioxane compound does not comprise homologous silsesquioxanes with x > 16 in amounts measurable by 1 H-NMR.

4. Method according to any of the preceding claims, comprising a further step prior to step a) of reacting a compound represented by the general formula SiₓHₓO_{1.5x} with an unsaturated hydrocarbon compound comprising R to obtain the silsesquioxane compound.

5. Method according to claim 4, wherein the unsaturated hydrocarbon compound comprising R is an olefin compound.

6. Method according to any of the preceding claims, wherein the method comprises a further step prior to step a) of treating the silsesquioxane compound with an acid.

7. Method according to claim 6, wherein the acid is an inorganic acid.

8. Method according to any of the preceding claims, wherein the method comprises a further step prior to step a) of treating the silsesquioxane compound with thermal energy using a temperature between 200°C to 400°C.

## Patentansprüche

1. Verfahren zum Herstellen einer elektronischen Vorrichtung, wobei das Verfahren die Schritte umfasst:
a) Bereitstellen, in einer Verdampfungsquelle, einer Silsesquioxanverbindung, die durch die allgemeine Formel SiₓRₓO_{1,5x} dargestellt ist,
wobei
R eine endständige Hydrocarbylgruppe ist, die kovalent an Si und die endständige Hydrocarbylgruppe gebunden ist, die mit mindestens einem Halogenatom substituiert ist und die zusätzlich mindestens ein Heteroatom ausgewählt aus der Gruppe bestehend aus B, Si, N, P, O und S umfassen kann; und
x unter 6, 8,10,12,14 und 16 ausgewählt ist; und
die Silsesquioxanverbindung im Wesentlichen frei von teilweise kondensierten Silsesquioxanen ist, was bedeutet, dass die Silsesquioxanverbindung keine teilweise kondensierten Silsesquioxane in Mengen umfasst, die durch ¹H-NMR messbar sind;
b) Verdampfen der Silsesquioxanverbindung durch Aufbringen von Wärmeenergie darauf
c) Absetzen der verdampften Silsesquioxanverbindung auf einem Substrat.

2. Verfahren nach Anspruch 1, wobei die Silsesquioxanverbindung im Wesentlichen frei von homologen Silsesquioxanen mit x < 6 ist, was bedeutet, dass die Silsesquioxanverbindung keine homologen Silsesquioxanverbindungen mit x < 6 in Mengen umfasst, die durch ¹H-NMR messbar sind.

3. Verfahren nach Anspruch 1 oder 2, wobei die Silsesquioxanverbindung im Wesentlichen frei von homologen Silsesquioxanen mit x > 16 ist, was bedeutet, dass die Silsesquioxanverbindung keine homologen Silsesquioxane mit x > 16 in Mengen umfasst, die durch ¹H-NMR messbar sind.

4. Verfahren nach einem der vorhergehenden Ansprüche, einen weiteren Schritt, vor Schritt a), des Reagierens einer Verbindung, die durch die allgemeine Formel SiₓHₓO_{1,5x} dargestellt ist, mit einer ungesättigten Kohlenwasserstoffverbindung, die R umfasst, um die Silsesquioxanverbindung zu erhalten, umfassend.

5. Verfahren nach Anspruch 4, wobei die ungesättigte Kohlenwasserstoffverbindung, die R umfasst, eine Olefinverbindung ist

6. Verfahren nach einem der vorhergehenden Ansprüche, wobei das Verfahren einen weiteren Schritt, vor Schritt a), des Behandelns der Silsesquioxanverbindung mit einer Säure umfasst.

7. Verfahren nach Anspruch 6, wobei die Säure eine anorganischen Säure ist.

8. Verfahren nach einem der vorhergehenden Ansprüche, wobei das Verfahren einen weiteren Schritt, vor Schritt a), des Behandelns der Silsesquioxanverbindung mit Wärmeenergie unter Anwendung einer Temperatur zwischen 200 °C und 400 °C umfasst.

## Revendications

1. Procédé de préparation d'un dispositif électronique, comprenant les étapes suivantes :
a) la mise à disposition, dans une source de vaporisation, d'un composé de silsesquioxane représenté par la formule générale SiₓRₓO_{1,5x},
dans lequel
R représente un groupe hydrocarbyle terminal lié de manière covalente à Si et au groupe hydrocarbyle terminal, qui est substitué par au moins un atome d'halogène et qui peut en outre comprendre au moins un hétéroatome choisi dans le groupe constitué par B, Si, N, P, O et S ; et
x est choisi parmi les nombres 6, 8, 10, 12, 14 et 16 ; et
le composé de silsesquioxane est pratiquement exempt de silsesquioxanes partiellement condensés, c'est-à-dire que le composé de silsesquioxane ne comprend pas de silsesquioxanes partiellement condensés en quantités mesurables par RMN-1H ;
b) la vaporisation du composé de silsesquioxane par application d'une énergie thermique ;
c) le dépôt du composé de silsesquioxane vaporisé sur un substrat

2. Procédé selon la revendication 1, dans lequel le composé silsesquioxane est sensiblement exempt de silsesquioxanes homologues avec x < 6, ce qui signifie que le composé de silsesquioxane ne comprend pas de silsesquioxanes homologues avec x < 6 en quantités mesurables par RMN-1H.

3. Procédé selon la revendication 1 ou la revendication 2, dans lequel le composé de silsesquioxane est sensiblement exempt de silsesquioxanes homologues avec x > 16, ce qui signifie que le composé de silsesquioxane ne comprend pas de silsesquioxanes homologues avec x > 16 en quantités mesurables par RMN-1 H.

4. Procédé selon l'une quelconque des revendications précédentes, comprenant une étape supplémentaire avant l'étape a) consistant à faire réagir un composé représenté par la formule générale SiₓRₓO_{1,5x} avec un composé hydrocarboné insaturé comprenant R pour obtenir le composé silsesquioxane.

5. Procédé selon la revendication 4, dans lequel le composé hydrocarboné insaturé comprenant R est un composé oléfinique.

6. Procédé selon l'une quelconque des revendications précédentes, dans lequel le procédé comprend une étape supplémentaire avant l'étape a) consistant à traiter le composé silsesquioxane avec un acide.

7. Procédé selon la revendication 6, dans lequel l'acide est un acide inorganique.

8. Procédé selon l'une quelconque des revendications précédentes, dans lequel le procédé comprend une étape supplémentaire avant l'étape a) consistant à traiter le composé de silsesquioxane avec de l'énergie thermique à une température comprise entre 200 °C et 400 °C.
